# EUROPEAN PATENT APPLICATION

(11) **EP 1 281 680 A2**
(43) Date of publication of application: **05.02.2003**
(21) Application number: 02255384.6
(22) Date of filing: 01.08.2002
(51) Int. Cl.: C03B 19/14

(54) **Method for making glass by plasma deposition and so obtained photomask material**

(30) Priority: 01.08.2001 US 920227
(71) Applicant: Corning Incorporated, Corning, New York 14831 (US)
(72) Inventor: The designation of the inventor has not yet been filed
(74) Representative: Marchant, James Ian

(57) **Abstract**

A method of making fused silica includes generating a plasma, delivering reactants comprising a silica precursor into the plasma to produce silica particles, and depositing the silica particles on a deposition surface to form glass.

## Description

### Background of Invention

### Field of the Invention

The invention relates generally to photomasks. More specifically, the invention relates to a method for making pure and water-free fused silica and use of the fused silica as photomask material.

### Background Art

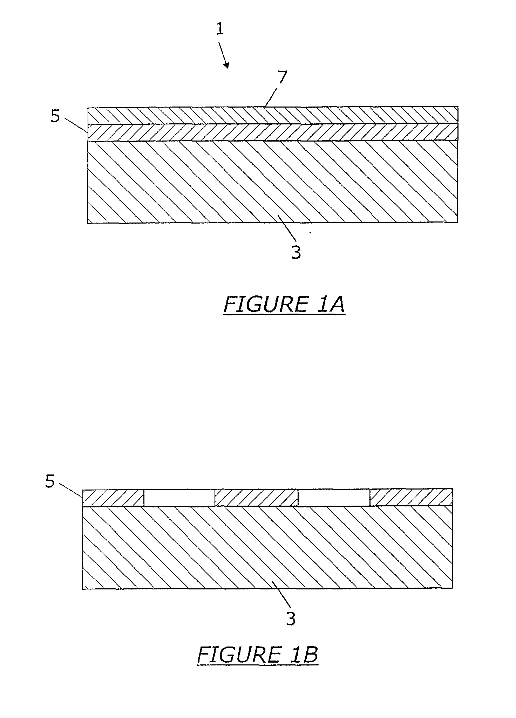

Photomasks are patterned substrates used in optical lithography processes for selectively exposing specific regions of a material to be patterned to radiation. Figure 1A shows a photomask blank **1** which includes a substrate **3** made of high-purity quartz or glass. The most common type of glass used is soda line. Quartz is more expensive than soda line and is typically reserved for critical photomask applications. The substrate **3** is usually coated with a thin uniform layer of chrome or iron oxide **5**. A chemical compound **7**, known as "photo-resist," is placed over the chrome or iron oxide layer **5**. Although not shown, an anti-reflective coating may also be applied over the chrome or iron oxide layer **5** before applying the photo-resist **7**. To form the photomask, a pattern is exposed onto the photo-resist **7** using techniques such as electron beam lithography. The pattern is then etched through the chrome or iron oxide layer **5**. Figure 1B shows a pattern etched in the chrome or iron oxide layer **5**.

For production of integrated circuits, the finished photomask contains high-precision images of integrated circuits. The integrated circuit images are optically transferred onto semiconductor wafers using suitable exposure beams. The resolution of the projected image is limited by the wavelength of the exposure beam. Currently, advanced microlithography tools use 248-nm radiation (KrF) laser or 193-nm radiation (ArF) laser to print patterns with line width as small as 0.25 µm. New microlithography tools using 157-nm (F₂) radiation are actively under development.

One of the primary challenges of developing 157-nm microlithography tools is finding a suitable material for the photomask substrate. Calcium fluoride is the main candidate for lens material at 157-nm but cannot be used as photomask material because it has a high coefficient of thermal expansion. Other fluoride crystal materials that have large band gaps and transmit at 157 nm are MgF₂ and LiF. However, MgF₂ has a high birefringence, and the manufacturing and polishing of LiF is unknown. Fused silica is used in 248-nm and 193-nm microlithography lenses. However, the fused silica produced by current processes is not adequate for use at 157-nm, primarily because transmission of the fused silica drops substantially at wavelengths below 185 nm. The drop in transmission has been attributed to the presence of residual water, *i.e.*, OH, H₂, and H₂O, in the glass, where the residual water is due to the hydrogen-rich atmosphere in which the glass is produced. Residual water has also been found to promote fluorine migration in fluorine-doped glass. Therefore a method for producing fused silica that does not contain residual water is desired.

High purity fused silica is commercially produced by the boule process. The boule process involves passing a silica precursor into a flame of a burner to produce silica soot. The soot is then directed downwardly into a refractory cup, where it is immediately consolidated into a dense, transparent, bulk glass, commonly called a "boule." This boule can be used as lens and photomask material at appropriate wavelengths. Because of environmental concerns, the silica precursor is typically a hydrogen-containing organic compound, such as octamethyltetrasiloxane (OMCTS) or silane, and the conversion flame is typically produced by burning a hydrogen-containing fuel, such as CH₄. Halogen-based silica precursors, particularly SiCl₄, are other types of silica precursors that can be used in the process. Flame combustion of SiCl₄ using hydrogen-containing fuel produces toxic and environmentally gases such as HCl.

### Summary of Invention

In one embodiment, the invention relates to a method of making fused silica which comprises generating a plasma, delivering reactants comprising a silica precursor into the plasma to produce silica particles, and depositing the silica particles on a deposition surface to form glass.

In another embodiment, the invention relates to a method of making fluorine-doped glass which comprises generating a plasma, delivering reactants comprising a silica precursor and a fluorine compound into the plasma to form fluorine-doped silica particles, and depositing the fluorine-doped silica particles on a deposition surface to form glass.

In another embodiment, the invention relates to a photomask material produced by a method comprising generating a plasma, delivering reactants comprising a silica precursor into the plasma to form silica particles, and depositing the silica particles on a deposition surface to form glass.

In another embodiment, the invention relates to a photomask for use at 157-nm comprising a silica glass made by plasma induction.

Other features and advantages of the invention will be apparent from the following description and the appended claims.

### Brief Description of Drawings

Figure 1A is a cross-section of a photomask blank.

Figure 1B is a cross-section of a photomask.

Figure 2 illustrates a system for producing fused silica by plasma induction.

Figure 3 is a plot of fluorine concentration for a fluorine-doped glass made by plasma induction.

Figure 4 is a chemical analysis of a silica glass made by plasma induction.

### Detailed Description

Embodiments of the invention provide a method for producing a pure and water-free fused silica by plasma induction. The fused silica produced by the method of the invention can be used as substrate material for 157-nm photomasks or in other applications requiring water-free fused silica, *e.g.*, infrared transmission.

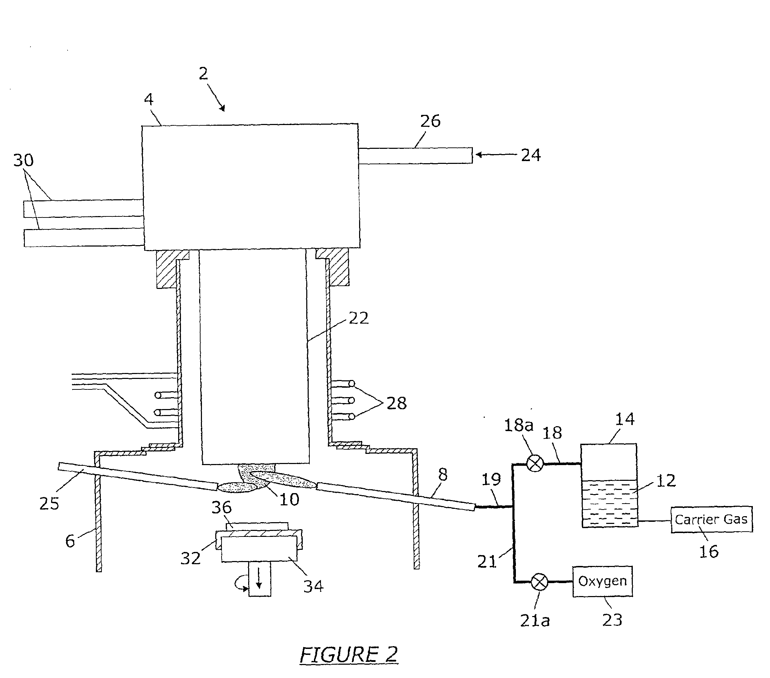

Specific embodiments of the invention will now be described with reference to the accompanying drawings. Figure 2 illustrates a system **2** for making fused silica by plasma induction. The system **2** includes an induction plasma torch **4** mounted on a reactor **6**, *e.g.,* a water-cooled, stainless reactor, and an injector **8** for injecting reactants into a plasma flame **10**. In the illustrated embodiment, the injector **8** is inserted through the wall of the reactor **6**. In other embodiments, the injector **8** may be inserted through the plasma torch **4** so as to inject the reactants through the plasma flame **10**. The reactants comprise a silica precursor and oxygen (or oxidant). The silica precursor can be any silicon-containing compound which exists in gaseous form or that is easily vaporized. For 157-nm applications, the silica precursor is preferably free of hydrogen. One possible silica precursor for this process is SiCl₄, SiCl₄ yields large amounts of vapors at low temperatures

In one embodiment, a liquid feedstock of SiCl₄ **12** (or other silica precursor) is vaporized in a container **14,** which may be an evaporator, vaporizer, bubbler, or other similar equipment for vaporizing the feedstock. An inert carrier gas **16** is bubbled through the liquid feedstock in the container **14.** The carrier gas **16** entrains the SiCl₄ vapors generated in the container **14** and transports the vapors to a tubing **18.** The carrier gas **16** could be any nonflammable gas such as nitrogen, noble gases (argon, helium, neon, krypton, xenon), or fluorinated gases, *e.g*., CF₄, chlorofluorocarbons, *e.g.,* CFₓCl₄₋ₓ, where x ranges from 1 to 3, NF₃, SF₆, SiF₄, C₂F₆, and F₂. Preferably, the tubing **18** is healed to prevent condensation of the vapors. The tubing **18** is connected to a tubing **19**, which is coupled to the injector **8.**

A tubing **21** carries a stream of oxygen **23** to the tubing **19.** The oxygen **23** mixes with the SiCl₄ **12** vapors, and the mixture is delivered to the injector **8.** The injector **8** projects the SiCl₄/O₂ mixture into the plasma flame **10.** Mass flow controllers **18a, 21a** are provided to control the rate at which the SiCl₄ **12** vapors and oxygen **23** are delivered to the injector **8.** The SiCl₄/O₂ mixture may be heated prior to being delivered to the injector **8.** In alternate embodiments, other reaciants, such as fluorinated gases, can be added to the SiCl₄/O₂ mixture. Alternatively, a dopant feed **25** inserted through the wall of the reactor **6** may be used to supply dopant materials toward or through the center of the plasma flame **10**. Examples of dopant materials include, but are not limited to, fluorinated gases and compounds capable of being converted to an oxide of B, Al, Ge, K, Ca, Sn, Ti, P, Se, Er, or S. Examples of fluorinated gases include, but are not limited to, CF₄, chlorofluorocarbons, *e.g.*, CFₓCl₄₋ₓ, where x ranges from 1 to 3, NF₃, SF₆, and SiF₄.

The plasma torch 4 reaction chamber includes a reaction tube **22** which defines a plasma production zone. Preferably, the reaction tube **22** is made of high-purity silica or quartz glass to avoid contaminating the fused silica being made with impurities. The reaction tube **22** receives plasma-generating gases **24** from a plasma-generating gas feed duct **26.** Examples of plasma-generating gases include argon, oxygen, air, and mixtures of these gases. The reaction tube **22** is surrounded by an induction coil **28,** which generates the induction current necessary to sustain plasma generation in the plasma production zone **24.** The induction coil **28** is connected to a high-frequency generator (not shown). Water coolers **30** are provided for cooling the plasma torch **6** during the plasma generation.

In operation, the plasma-generating gases **24** are fed into the reaction tube **22**. The induction coil **28** generates a high-frequency alternating magnetic field which ionizes the plasma-generating gases **24** inside the reaction tube **22** to produce the plasma flame **10.** The injector **8** is then operated to project the SiCl₄/O₂ mixture into the plasma flame **10.** SiCl4 is oxidized in the plasma flame **10** to produce silica particles, which are deposited on a substrate **32** on a rotating table **34**. The substrate **32** is typically made of high purity fused silica. As previously mentioned, the dopant **25** may also supply a dopant material toward or through the plasma **10** to produce doped silica particles. In one embodiment, the heat generated by the plasma torch **6** is sufficient to heat the substrate **32** to consolidation temperatures, typically 1500 to 1800°F, so that the silica particles deposited on the substrate **32** immediately consolidate into glass **36**.

As shown, the rotating table **34** which supports the deposition substrate **32** is located within the reactor **6.** The atmosphere in the reactor **6** is controlled and sealed from the surrounding atmosphere so that a glass that is substantially free of water is produced. In one embodiment, the atmosphere in the reactor **6** is controlled so that a water vapor content in the reactor **6** is less than 1 ppm by volume. This may be achieved, for example, by purging the reactor **6** with an inert gas or dry air and using a desiccant, such as zeolite, to absorb moisture.

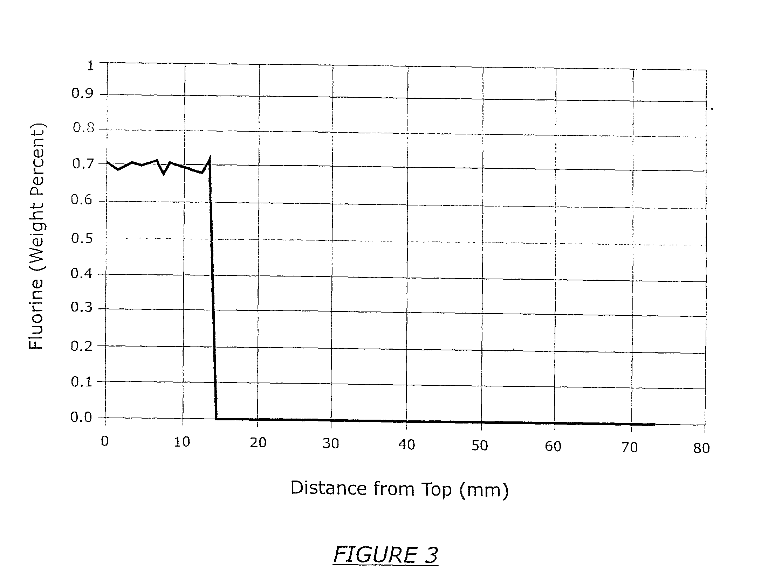

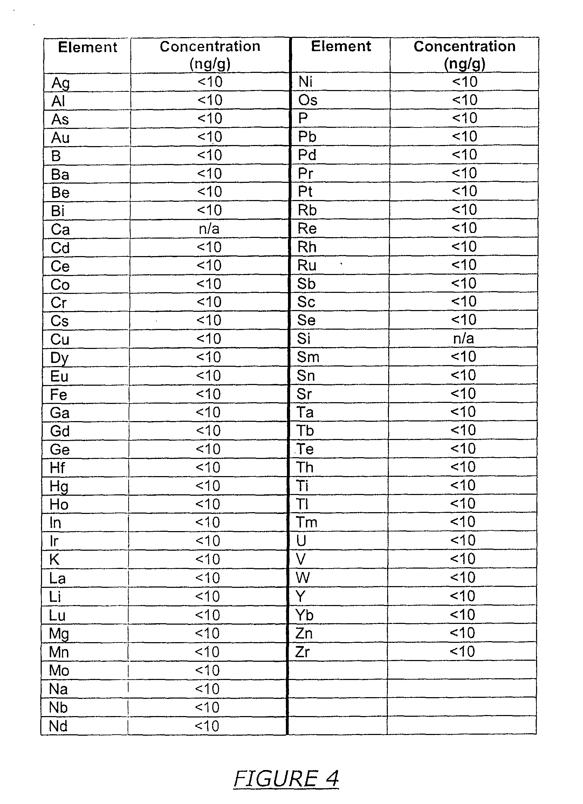

The invention provides several advantages. One advantage of the invention is that a pure, water-free fused silica can be produced by plasma induction. This fused silica can be polished and used as photomask material for 157-nm microlithography tools and in other applications requiring water-free fused silica. Another advantage is that the fused silica can be produced in one step, *i.e*., deposition and consolidation into glass is done at the same time. Another advantage is the ability to achieve uniform doping of fluorine with no migration. Figure 3 is a plot of fluorine concentration for a fluorine-doped piece of silica glass produced by the method described above. The silica glass has approximately 0.7 weight percent of fluorine, and there is no migration of fluorine. Another benefit is that the silica glass is very clean. In employing a refractory-free process, the glass is free of contamination. This is a huge advantage over the current fused silica process that uses refractories. Figure 4 shows the chemical analysis of a glass made by plasma induction.

While the invention has been described with respect to a limited number of embodiments, those skilled in the art, having benefit of this disclosure, will appreciate that other embodiments can be devised which do not depart from the scope of the invention as disclosed herein. Accordingly, the scope of the invention should be limited only by the attached claims.

## Claims

1. A method of making fused silica, comprising:
generating a plasma;
delivering reactants comprising a silica precursor into the plasma to produce silica particles; and
depositing the silica particles on a deposition surface to form glass.

2. The method of claim **1**, wherein delivering reactants comprising a silica precursor into the flame further comprises delivering a dopant material into the plasma to form doped silica particles.

3. The method of claim **2**, wherein the dopant material comprises a compound capable of being converted to an oxide of at least one member of the group consisting of B, Al, Ge, K, Ca, Sn, Ti, P, Se, Er, and S.

4. The method of claim **2**, wherein the dopant material comprises a fluorine compound selected from the group consisting of CF₄, CFₓCl₄₋ₓ, where x ranges from 1 to 3, NF₃, SF₆, SiF₄, C₂F₆, and F₂.

5. The method of claim 4, wherein the silica precursor comprises SiCl₄.

6. A method of making fluorine-doped glass, comprising:
generating a plasma;
delivering reactants comprising a silica precursor and a fluorine compound into the plasma to form fluorine-doped silica particles; and
depositing the fluorine-doped silica particles on a deposition surface to form glass.

7. The method of claim 6, wherein the silica precursor and fluorine compound selected from the group consisting of CF₄, CFₓCl₄₋ₓ, where x ranges from 1 to 3, NF₃, SF₆, SiF₄, C₂F₆, and F₂ are delivered into the plasma in gaseous form.

8. The method of claim 6, wherein the silica precursor comprises SiCl₄.

9. A photomask material produced by a method comprising:
generating a plasma;
delivering reactants comprising a silica precursor into the plasma to form silica particles; and
depositing the silica particles on a deposition surface to form glass.

10. The photomask material of claim 9, wherein the silica precursor comprises SiCl₄.

11. The photomask material of claim 10, further comprising delivering a dopant material into the plasma to form doped silica particles, wherein the dopant material comprises a fluorine compound is selected from the group consisting of CF₄, CFₓCl₄₋ₓ, where x ranges from 1 to 3, NF₃, SF₆, SiF₄, C₂F₆, and F₂.

12. A photomask for use at 157-nm comprising a silica glass made by plasma induction.
